(19) Europäisches Patentamt
European Patent Office
Office européen des brevets

(11) **EP 2 732 448 B1**

(12) **FASCICULE DE BREVET EUROPEEN**

(45) Date de publication et mention
de la délivrance du brevet:
**09.09.2015 Bulletin 2015/37**

(21) Numéro de dépôt: **12744070.9**

(22) Date de dépôt: **09.07.2012**

(51) Int Cl.:
$G10L\ 19/02^{(2013.01)}$      $G10L\ 19/022^{(2013.01)}$

(86) Numéro de dépôt international:
**PCT/FR2012/051622**

(87) Numéro de publication internationale:
**WO 2013/007943 (17.01.2013 Gazette 2013/03)**

(54) **ADAPTATIONS DE FENÊTRES DE PONDÉRATION D'ANALYSE OU DE SYNTHÈSE POUR UN CODAGE OU DÉCODAGE PAR TRANSFORMÉE**

ANPASSUNGEN VON ANALYSE- ODER SYNTHESEGEWICHTUNGSFENSTERN ZUR TRANSFORMATIONSKODIERUNG ODER -DEKODIERUNG

ADAPTATIONS OF ANALYSIS OR SYNTHESIS WEIGHTING WINDOWS FOR TRANSFORM CODING OR DECODING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.07.2011 FR 1156356**

(43) Date de publication de la demande:
**21.05.2014 Bulletin 2014/21**

(73) Titulaire: **Orange
75015 Paris (FR)**

(72) Inventeurs:
• **FAURE, Julien
22300 Ploubezre (FR)**
• **PHILIPPE, Pierrick
35520 Melesse (FR)**

(56) Documents cités:
**WO-A1-2006/110975     WO-A1-2010/012925
US-B1- 6 748 363**

• **PLOTKIN E ET AL: "Nonuniform sampling of bandlimited modulated signals", SIGNAL PROCESSING, ELSEVIER SCIENCE PUBLISHERS B.V. AMSTERDAM, NL, vol. 4, no. 4, 1 juillet 1982 (1982-07-01) , pages 295-303, XP024231148, ISSN: 0165-1684, DOI: 10.1016/0165-1684(82)90005-6 [extrait le 1982-07-01]**

## Description

La présente invention concerne un traitement de signal, notamment un signal audio (tel un signal de parole) et/ou vidéo, sous forme d'une succession d'échantillons. Elle concerne en particulier le codage et le décodage d'un signal audionumérique par transformée et l'adaptation des fenêtres d'analyse ou de synthèse à la taille de la transformée.

Le codage par transformée consiste à coder des signaux temporels dans le domaine transformé (fréquentiel). Cette transformation permet notamment d'utiliser les caractéristiques fréquentielles des signaux audio afin d'optimiser et d'améliorer les performances de codage. On utilise par exemple le fait qu'un son harmonique est représenté dans le domaine fréquentiel par un nombre réduit de raies spectrales qui peuvent ainsi être codées de manière concise. On utilise aussi par exemple avantageusement les effets de masquage fréquentiels pour mettre en forme le bruit de codage de manière à ce qu'il soit le moins audible possible.

Classiquement, le codage et décodage par transformée s'effectue par application de cinq étapes:

- Le flux audio numérique (échantillonné à une fréquence d'échantillonnage Fs donnée) à coder, est sectionné en trames de nombre d'échantillons finis (par exemple 2N). Chaque trame se recouvre classiquement à 50 % avec la trame précédente.
- Une étape de transformation est appliquée au signal. Dans le cas de la transformation appelée MDCT (pour "Modified Discrete Cosine Transform" en anglais), une fenêtre de pondération $h_a$ (appelée fenêtre d'analyse) de taille L=2N est appliquée à chaque trame.

La trame pondérée est « repliée » suivant une transformation 2N vers N. Le « repliement » de la trame $T_{2N}$ de taille 2N pondérée par $h_a$ vers la trame $T_N$ de taille N peut par exemple être fait de la manière suivante :

$$\left[\begin{array}{l} T_N(k) = -T_{2N}\left(\frac{3N}{2}-k-1\right)h_a\left(\frac{3N}{2}-k-1\right) - T_{2N}\left(\frac{3N}{2}+k\right)h_a\left(\frac{3N}{2}+k\right) \\ T_N(N/2+k) = \quad T_{2N}(k)h_a(k) - T_{2N}(N-k-1)h_a(N-k-1) \end{array}\right. \quad (1)$$
$$k \in [0; N/2-1]$$

une DCT IV est appliqué à la trame repliée $T_N$ afin d'obtenir une trame de taille N dans le domaine transformé. Elle s'exprime de la façon suivante:

$$T'_N(u) = \sqrt{\frac{2}{M}} \sum_{k=0}^{N-1} T_N(k)\cos\left[\frac{\pi}{M}\left(k+\frac{1}{2}\right)\left(u+\frac{1}{2}\right)\right]$$

- La trame dans le domaine transformé est alors quantifiée en utilisant un quantificateur adapté. La quantification permet de réduire la taille des données à transmettre mais introduit un bruit (audible ou non) à la trame originale. Plus le débit du codec est élevé, plus ce bruit est réduit et plus la trame quantifiée est proche de la trame originale.
- Une transformation MDCT inverse est appliquée au décodage à la trame quantifiée. Elle comporte deux étapes : La trame quantifiée de taille N est convertie en trame de taille N dans le domaine temporel $T_N^*$ en utilisant une DCT IV inverse (qui s'exprime comme une transformation directe).
  Une deuxième étape de « dépliement» de N vers 2N est alors appliquée à la trame temporelle $T_N^*$ de taille N. Des fenêtres de pondération $h_s$ dites de synthèse sont appliquées aux trames $T_{2N}^*$ de tailles 2N selon l'équation suivante:

$$\left[\begin{array}{l} T_{2N}^*(k) = T_N^*\left(\frac{N}{2}+k\right)h_s(k) \\ T_{2N}^*\left(\frac{N}{2}+k\right) = -T_N^*(N-k-1)h_s\left(\frac{N}{2}+k\right) \\ T_{2N}^*(N+k) = -T_N^*\left(\frac{N}{2}-k-1\right)h_s(N+k) \\ T_{2N}^*\left(\frac{3N}{2}+k\right) = -T_N^*(k)h_s\left(\frac{3N}{2}+k\right) \end{array}\right. \quad (2)$$
$$k \in [0; N/2-1]$$

- Le flux audio décodé est alors synthétisé en sommant les parties en recouvrement de deux trames consécutives

Notons que ce schéma s'étend à des transformations ayant un recouvrement plus important, telles que les ELT pour lesquelles les filtres d'analyse et de synthèse ont une longueur L=2KN pour un recouvrement de (2K-1)N. La MDCT est ainsi un cas particulier de l'ELT avec K=1.

Pour une transformée et un recouvrement donné, on détermine des fenêtres d'analyse et de synthèse qui permettent d'obtenir une reconstruction dite "parfaite" du signal à coder (en l'absence de quantification).

La reconstruction peut également être à reconstruction "quasi-parfaite" lorsque la différence entre les signaux d'origine X et reconstruit X peut être considérée négligeable. Par exemple, en codage audio, une différence ayant une puissance d'erreur 50dB plus faible que la puissance du signal X traité peut être considéré comme négligeable.

Par exemple, dans le cas où les fenêtres d'analyse et de synthèse ne changent pas sur deux trames consécutives, elles doivent respecter les conditions de reconstruction parfaites suivantes :

$$\begin{bmatrix} h_a(N+k)h_s(N+k) + h_a(k)h_s(k) = 1 \\ h_a(N+k)h_s(2N-k-1) - h_a(k)h_s(N-1-k) = 0 \end{bmatrix} \quad (3)$$
$$k \in [0; N-1]$$

Ainsi, on comprend aisément que dans la plupart des codecs, les fenêtres d'analyse et de synthèse sont stockées en mémoire, elles sont soit calculées à l'avance et stockées en mémoire ROM, soit initialisées à l'aide de formules et néanmoins stockées en mémoire RAM.

La plupart du temps, les fenêtres d'analyse et de synthèse sont identiques $(h_s(k)=h_a(k))$, parfois à un retournement d'indice près $(h_s(k)=h_a(2N-1-k))$, elles ne nécessitent alors qu'un seul espace mémoire de taille 2N pour leur stockage en mémoire.

Les nouveaux codecs fonctionnent avec des tailles de trame N différentes, que ce soit pour gérer plusieurs fréquences d'échantillonnage, ou pour adapter la taille de la fenêtre d'analyse (et donc de synthèse) au contenu audio (par exemple dans le cas de transitions). Dans ces codecs, on trouve en mémoire ROM ou en RAM autant de fenêtres d'analyse et/ou de synthèse que de tailles de trames différentes.

Les coefficients (appelés également échantillons) des fenêtres d'analyse ou de synthèse, du codeur ou du décodeur, doivent être stockés en mémoire afin de réaliser la transformée d'analyse ou de synthèse. Bien entendu, dans un système particulier utilisant des transformées de tailles différentes, la fenêtre de pondération pour chacune des tailles utilisées doit être représentée en mémoire.

Dans le cas favorable où les fenêtres sont symétriques, seuls *L*/2 coefficients ont besoin d'être stockés, les *L*/2 autres se déduisant sans opération arithmétique de ces coefficients stockés. Ainsi, pour une MDCT (*K=1*), si on a besoin d'une transformée de taille M et 2.M alors il faut stocker *(M+2M)=3M* coefficients si les fenêtres sont symétriques et *(2M+4M)=6M* sinon. Un exemple typique pour le codage audio est *M=320* ou *M=1024*. Ainsi, pour le cas asymétrique cela impose le stockage de 1920 et 6144 coefficients respectivement.

Selon la précision souhaitée pour la représentation des coefficients, 16 bits voire 24 bits pour chaque coefficient sont nécessaires. Cela implique un espace mémoire non négligeable pour des calculateurs de bas coût.

Des techniques de décimation de fenêtre d'analyse ou de synthèse existent.

Une décimation simple de fenêtre, par exemple lorsque l'on veut passer de N échantillons à M (N étant un multiple de M), consiste à prendre un échantillon sur N/M avec N/M un entier > 1.

Un tel calcul ne permet pas de respecter l'équation de reconstruction parfaite donnée en équation (3).

Par exemple, dans le cas où la fenêtre de synthèse est le retourné temporel de la fenêtre d'analyse, on a:

$$h_s(2N-k-1) = h_a(k) = h(k)$$
$$\text{pour } k \in [0; 2N-1] \quad (4)$$

La condition de reconstruction parfaite devient :

$$h(N+k)h(N-k-1) + h(k)h(2N-k-1) = 1$$
$$\text{pour } k \in [0; 2N-1] \quad (5)$$

Une fenêtre classiquement utilisée en codage pour répondre à cette condition est la fenêtre sinusoïdale de Malvar:

$$h(k) = \sin\left(\tfrac{\pi}{2N}\left(k + 0.5\right)\right)$$
$$\text{pour } k \in [0; 2N-1] \quad\quad (6)$$

Si la fenêtre h(k) est décimée en prenant un échantillon sur N/M, cette fenêtre devient:

$$h^*(k) = h\left(\tfrac{kN}{M}\right) = \sin\left(\tfrac{\pi}{2N}\left(\tfrac{kN}{M} + 0.5\right)\right)$$
$$\text{pour } k \in [0; 2M-1]$$

Pour que h*(k) de taille 2M vérifie la condition de reconstruction parfaite (à l'équation (3)),

$$h^*(M+k)h^*(M-k-1) + h^*(k)h^*(2M-k-1) = \cos\left(\tfrac{\pi}{2N}\left(\tfrac{kN}{M}+0.5\right)\right)\cos\left(\tfrac{\pi}{2N}\left(\tfrac{kN}{M}+\tfrac{N}{M}-0.5\right)\right)$$
$$+ \sin\left(\tfrac{\pi}{2N}\left(\tfrac{kN}{M}+0.5\right)\right)\sin\left(\tfrac{\pi}{2N}\left(\tfrac{kN}{M}+\tfrac{N}{M}-0.5\right)\right)$$
$$= 1$$
$$\text{pour } k \in [0; M-1]$$

N/M doit être égal à 1; or N/M est défini comme un entier > 1 donc pour une telle décimation, la condition de reconstruction parfaite ne peut être vérifiée.

L'exemple illustratif pris ici se généralise aisément. Ainsi, par décimation directe d'une fenêtre de base pour obtenir une fenêtre de taille réduite, la propriété de reconstruction parfaite ne peut être assurée.

Des techniques d'interpolation de fenêtres de pondération existent aussi. Une telle technique est par exemple décrite dans la demande de brevet publiée EP 2319039. Cette technique permet de réduire la taille de fenêtres stockées en ROM lorsque l'on a besoin d'une fenêtre de taille plus importante.

Ainsi, au lieu de stocker une fenêtre de taille 2N et une fenêtre de taille 4N la demande de brevet propose d'affecter les échantillons de la fenêtre 2N à un échantillon sur deux de la fenêtre 4N et de stocker en ROM uniquement les 2N échantillons manquant. La taille de stockage en ROM est ainsi réduite de 4N + 2N à 2N + 2N.

Toutefois, cette technique nécessite également un pré-calcul de fenêtre d'analyse et de synthèse avant d'appliquer la transformée proprement dite.

Il existe donc un besoin de ne stocker qu'un nombre réduit de fenêtres d'analyse et de fenêtres de synthèse en mémoire pour appliquer des transformées de différentes taille tout en respectant les conditions de reconstruction parfaite. De plus, le besoin d'éviter les étapes de pré-calcul de ces fenêtres avant le codage par transformée est également ressenti.

La présente invention vient améliorer la situation.

Elle propose à cet effet, un procédé de codage ou de décodage par transformée d'un signal audionumérique utilisant des fenêtres de pondération d'analyse ($h_a$) ou de synthèse ($h_s$) appliquées à des trames d'échantillons. Le procédé est tel qu'il comporte un échantillonnage irrégulier (E10) d'une fenêtre initiale prévue pour une transformée de taille initiale N donnée, pour appliquer une transformation secondaire de taille M différente de N, l'étape d'échantillonnage comportant la sélection à partir d'un premier coefficient d de la fenêtre initiale avec 0≤d<N/M, d'un ensemble défini de coefficients N-d-1, N+d, 2N-d-1, respectant une condition prédéterminée de reconstruction parfaite.

Ainsi, à partir d'une fenêtre initiale stockée, prévue pour une transformée de taille N, il est possible d'appliquer une transformation de taille différente sans que des pré-calculs soient effectués et sans que d'autre fenêtres de tailles différentes ne soient stockées.

Une seule fenêtre de taille quelconque peut ainsi suffire pour l'adapter à des transformées de taille différentes. L'échantillonnage irrégulier permet de respecter les conditions de reconstruction dite "parfaite" ou "quasi-parfaite" lors du décodage.

Ainsi, il est possible à partir d'un ensemble de coefficients de déterminer des fenêtres adaptées à des transformées secondaires de tailles différentes tout en respectant les conditions de reconstruction parfaites.

Les différents modes particuliers de réalisation mentionnés ci-après peuvent être ajoutés indépendamment ou en combinaison les uns avec les autres, aux étapes du procédé de codage ou de décodage défini ci-dessus.

Avantageusement lorsque N est supérieur à M, une décimation de la fenêtre initiale s'effectue en conservant au minimum les coefficients de l'ensemble défini pour obtenir une fenêtre décimée..

Ainsi, à partir d'une fenêtre d'analyse ou de synthèse stockée de taille supérieure, il est possible d'obtenir une fenêtre de dimension inferieure qui respecte également les conditions de reconstruction parfaite au décodage.

Dans un exemple particulier de réalisation, le procédé comporte la sélection d'un deuxième ensemble de coefficients espacés d'un écart constant avec les coefficients de l'ensemble défini et la décimation s'effectue en conservant en outre les coefficients du deuxième ensemble pour obtenir la fenêtre décimée.

Ainsi, une décimation adaptée à la taille de transformée voulue peut être obtenue. Ceci permet de conserver au mieux la réponse en fréquence des fenêtres obtenues.

Dans un mode particulier de réalisation, la décimation d'une fenêtre de taille 2N en une fenêtre de taille 2M s'effectue selon les équations suivantes:

$$\text{pour } k \in [0; M/2-1]$$

$$\begin{bmatrix} h^*(k) = h\left(\left\lceil k\frac{N}{M}\right\rceil + d\right) \\ h^*(2M-k-1) = h\left(2N-1-k\frac{N}{M}\right\rfloor - d\right) \\ h^*(M+k) = h\left(\left\lceil N+k\frac{N}{M}\right\rceil + d\right) \\ h^*(M-k-1) = h\left(\left\lfloor N-1-k\frac{N}{M}\right\rfloor - d\right) \end{bmatrix}$$

où h* est la fenêtre d'analyse ou de synthèse décimée, h est la fenêtre d'analyse ou de synthèse initiale, $\lfloor X \rfloor$ est l'entier le plus proche $\leq X$, $\lceil X \rceil$ est l'entier le plus proche $\geq X$ et d est la valeur du premier coefficient de l'ensemble défini.

Ainsi, il est possible d'obtenir des fenêtres de tailles différentes à partir d'une fenêtre de taille supérieure même lorsque le nombre de coefficients entre la fenêtre initiale et la fenêtre obtenue n'est pas multiple.

Lorsque N est inférieur à M, une interpolation s'effectue en insérant un coefficient entre chacun des coefficients de l'ensemble de coefficients définis et chacun des coefficients d'un ensemble de coefficients adjacents pour obtenir une fenêtre interpolée.

La fenêtre interpolée respecte également une reconstruction parfaite et peut être calculé à la volée à partir d'une fenêtre stockée de taille inférieure.

Dans un mode particulier de réalisation, le procédé comporte la sélection d'un deuxième ensemble de coefficients espacés d'un écart constant avec les coefficients de l'ensemble défini et l'interpolation s'effectue en insérant en outre un coefficient entre chacun des coefficients du deuxième ensemble et chacun des coefficients d'un ensemble de coefficients adjacents pour obtenir la fenêtre interpolée.

Ainsi, une interpolation adaptée à la taille de la transformée voulue peut être obtenue. Ceci permet de conserver au mieux la réponse en fréquence des fenêtres obtenues.

De façon à optimiser la réponse en fréquence de la fenêtre interpolée, dans un mode de réalisation particulier, le procédé comporte le calcul d'une fenêtre complémentaire comportant des coefficients calculés à partir des coefficients de l'ensemble définis et des coefficients adjacents, pour interpoler ladite fenêtre.

Dans un mode privilégié de réalisation l'étape d'échantillonnage irrégulier et une décimation ou interpolation de la fenêtre initiale sont effectuées lors de l'étape de mise en oeuvre du repliement ou du dépliement temporel utilisé pour le calcul de la transformée secondaire.

Ainsi, la décimation ou l'interpolation d'une fenêtre d'analyse ou de synthèse est effectuée en même temps que l'étape de transformée proprement dite, donc à la volée. Il n'est donc plus utile d'effectuer des étapes de pré-calculs avant le codage, l'obtention de fenêtres adaptées à la taille de la transformée s'effectuant lors du codage.

Dans un exemple de réalisation, à la fois une décimation et une interpolation de la fenêtre initiale sont effectuées lors de l'étape de mise en oeuvre du repliement ou du dépliement temporel utilisé pour le calcul de la transformée secondaire.

Cela permet d'offrir plus de possibilités d'obtention de fenêtres de différentes tailles à partir d'une seule fenêtre stockée en mémoire.

Dans un cas particulier de réalisation pour la décimation la décimation lors du repliement temporel s'effectue selon l'équation suivante:

$$\left[\begin{array}{l} T_M(k) = -T_{2M}\left(\frac{3M}{2} - k - 1\right)h_a\left(\left\lceil\frac{3N}{2} - (k+1)\frac{N}{M}\right\rceil + d\right) - T_{2M}\left(\frac{3M}{2} + k\right)h_a\left(\left\lfloor\frac{3N}{2} - 1 + (k+1)\frac{N}{M}\right\rfloor - d\right) \\ T_M(M/2 + k) = T_{2M}(k)h_a\left(\left\lceil k\frac{N}{M}\right\rceil + d\right) - T_{2M}(M - k - 1)h_a\left(\left\lfloor N - 1 - k\frac{N}{M}\right\rfloor - d\right) \end{array}\right.$$

$$k \in [0; M/2 - 1]$$

avec $T_M$ une trame de M échantillons, $T_{2M}$, une trame de 2M échantillons et la décimation lors du dépliement temporel s'effectue selon l'équation suivante:

$$\left[\begin{array}{l} T_{2M}^*(k) = T_M^*\left(\frac{M}{2} + k\right)h_s\left(\left\lceil k\frac{N}{M}\right\rceil + d\right) \\ T_{2M}^*\left(\frac{M}{2} + k\right) = -T_M^*(M - k - 1)h_s\left(\left\lfloor\frac{N}{2} - 1 + (k+1)\frac{N}{M}\right\rfloor - d\right) \\ T_{2M}^*(M + k) = -T_M^*\left(\frac{M}{2} - k - 1\right)h_s\left(\left\lceil N + k\frac{N}{M}\right\rceil + d\right) \\ T_{2M}^*\left(\frac{3M}{2} + k\right) = -T_M^*(k)h_s\left(\left\lfloor\frac{3N}{2} - 1 + (k+1)\frac{N}{M}\right\rfloor - d\right) \end{array}\right.$$

$$k \in [0; N/2 - 1]$$

avec $T_M^*$ une trame de M échantillons, $T_{2M}^*$, une trame de 2M échantillons.

Dans un exemple de réalisation particulièrement adapté, lorsque la transformée secondaire est de taille M=3/2N, une décimation de la fenêtre initiale puis une interpolation est effectuée lors du repliement temporel selon les équations suivantes:

$$\left[\begin{array}{l} T_M(k+1) = -T_{2M}\left(\frac{3M}{2} - (k+1) - 1\right)h\left(\frac{3N}{2} - k/2 - 1\right) - T_{2M}\left(\frac{3M}{2} + k + 1\right)h\left(\frac{3N}{2} + k/2\right) \\ T_M(k) = -T_{2M}\left(\frac{3N}{2} - k - 1\right)hcomp\left(\frac{3N}{2} - k/2 - 1\right) - T_{2M}\left(\frac{3N}{2} + k\right)hcomp\left(\frac{3N}{2} + k/2\right) \\ T_M(N/2 + k) = T_{2M}(k)h(k/2) - T_{2M}(N - k - 1)h(N - k/2 - 1) \\ T_M(N/2 + k + 1) = T_{2M}(k+1)hcomp(k/2) - T_{2M}(N - (k+1) - 1)hcomp(N - k/2 - 1) \end{array}\right.$$

$$k/2 \in [0; N/2 - 1]$$

avec $T_M$ une trame de M échantillons, $T_{2M}$, une trame de 2M échantillons, hcomp la fenêtre complémentaire et lorsque la transformée secondaire est de taille M=3/2N, une décimation de la fenêtre initiale puis une interpolation est effectuée lors du dépliement temporel selon les équations suivantes:

$$\left[\begin{array}{l} T_{2M}^*(k) = T_M^*\left(\frac{N}{2} + k\right)h(2N - k/2 - 1) \\ T_{2M}^*(k+1) = T_M^*\left(\frac{N}{2} + k + 1\right)hcomp(2N - k/2 - 1) \\ T_{2M}^*\left(\frac{N}{2} + k + 1\right) = -T_M^*(N - (k+1) - 1)h\left(\frac{3N}{2} - k/2 - 1\right) \\ T_{2M}^*\left(\frac{N}{2} + k\right) = -T_M^*(N - k - 1)hcomp\left(\frac{3N}{2} - k/2 - 1\right) \\ T_{2M}^*(N + k) = -T_M^*\left(\frac{N}{2} - k - 1\right)h(N - k/2 - 1) \\ T_{2M}^*(N + k + 1) = -T_M^*\left(\frac{N}{2} - (k+1) - 1\right)hcomp(N - k/2 - 1) \\ T_{2M}^*\left(\frac{3N}{2} + k + 1\right) = -T_M^*(k+1)h\left(\frac{N}{2} - k/2 - 1\right) \\ T_{2M}^*\left(\frac{3N}{2} + k\right) = -T_M^*(k)hcomp\left(\frac{N}{2} - k/2 - 1\right) \end{array}\right.$$

$$k/2 \in [0; N/2 - 1]$$

avec $T_M$ une trame de M échantillons, $T_{2M}$, une trame de 2M échantillons, hcomp la fenêtre complémentaire.

La présente invention vise également un dispositif de codage ou de décodage par transformée d'un signal audionumérique utilisant des fenêtres de pondération d'analyse ou de synthèse appliquées à des trames d'échantillons. Le dispositif est tel qu'il comporte un module d'échantillonnage apte à échantillonner de façon irrégulière une fenêtre initiale prévue pour une transformée de taille initiale N donnée, pour appliquer une transformation secondaire de taille M différente de N, l'échantillonnage comportant la sélection à partir d'un premier coefficient d de la fenêtre initiale avec $0 \leq d < N/M$, d'un ensemble défini de coefficients N-d-1, N+d, 2N-d-1, respectant une condition prédéterminée de reconstruction parfaite.

Ce dispositif présente les mêmes avantages que le procédé décrit précédemment, qu'il met en oeuvre.

Elle vise un programme informatique comportant des instructions de code pour la mise en oeuvre des étapes du procédé de codage ou de décodage tel que décrit, lorsque ces instructions sont exécutées par un processeur.

Enfin l'invention se rapporte à un support de stockage, lisible par un processeur, intégré ou non au dispositif de codage ou de décodage, éventuellement amovible, mémorisant un programme informatique mettant en oeuvre un procédé de codage ou de décodage tel que décrit précédemment.

D'autres caractéristiques et avantages de l'invention apparaîtront plus clairement à la lecture de la description suivante, donnée uniquement à titre d'exemple non limitatif, et faite en référence aux dessins annexés, sur lesquels :

- la figure 1 illustre un exemple de système de codage et décodage mettant en oeuvre l'invention dans un mode de réalisation;
- la figure 2 illustre un exemple de décimation de fenêtre d'analyse et de synthèse selon l'invention;
- la figure 3 illustre un échantillonnage irrégulier d'une fenêtre d'analyse ou de synthèse pour l'obtention d'une fenêtre selon un mode de réalisation de l'invention;
- les figures 4(a) et 4(b) illustrent un échantillonnage irrégulier d'une fenêtre d'analyse ou de synthèse d'un facteur rationnel (2/3) dans un mode de réalisation de l'invention. La figure 4 (a) illustre une sous étape de décimation alors que 4(b) présente une sous étape d'interpolation; et
- la figure 5 illustre un exemple de réalisation matérielle d'un dispositif de codage ou de décodage selon l'invention.

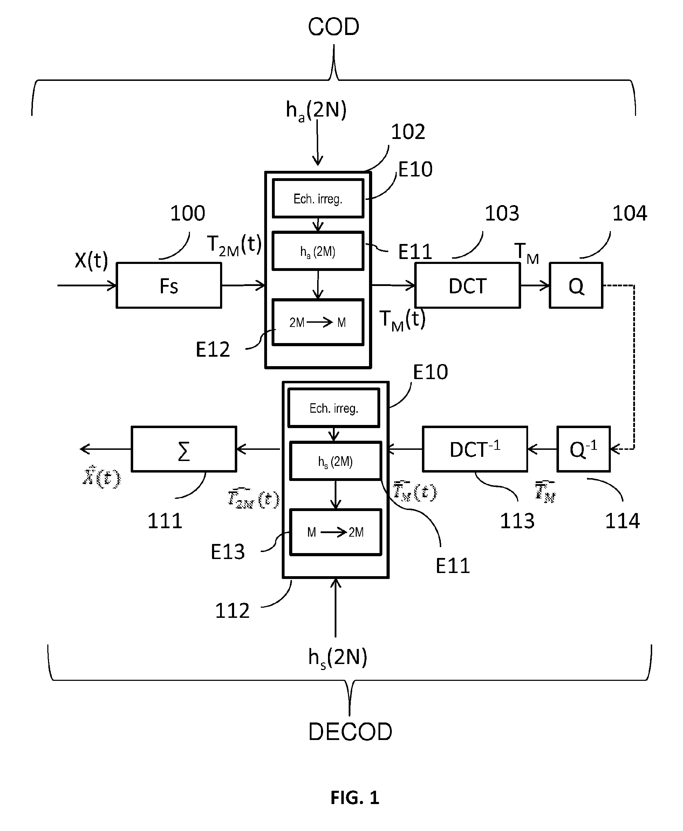

La **figure 1** illustre un système de codage et de décodage par transformée dans lequel une unique fenêtre d'analyse et une unique fenêtre de synthèse de taille 2N sont stockées en mémoire.

Le flux audio numérique X(t) est échantillonné par le module d'échantillonnage 101 à une fréquence d'échantillonnage $F_s$, des trames $T_{2M}(t)$ de 2M échantillons étant ainsi obtenues. Chaque trame se recouvre classiquement à 50% avec la trame précédente.

Une étape de transformation est ensuite appliquée au signal par les blocs 102 et 103. Le bloc 102 effectue un échantillonnage de la fenêtre initiale stockée prévue pour une transformée de taille N pour appliquer une transformation secondaire de taille M différente de N. Un échantillonnage de la fenêtre d'analyse $h_a$ de 2N coefficients est alors effectué pour l'adapter aux trames de 2M échantillons du signal.

Dans le cas où N est un multiple M, il s'agit d'une décimation et dans le cas où N est un sous multiple de M, il s'agit d'une interpolation. On prévoit le cas où N/M est quelconque.

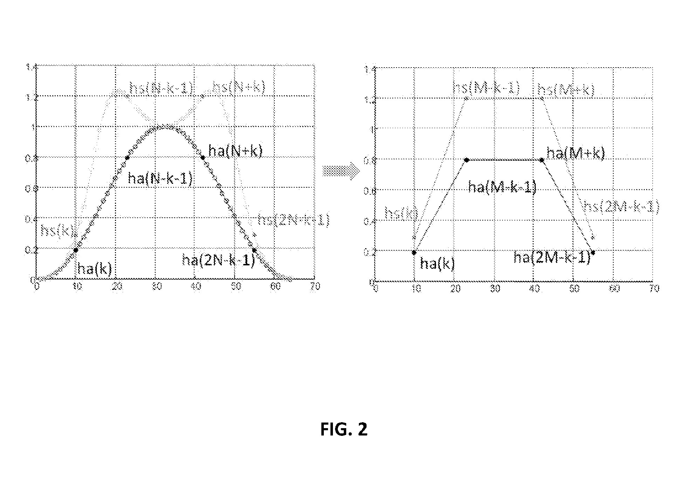

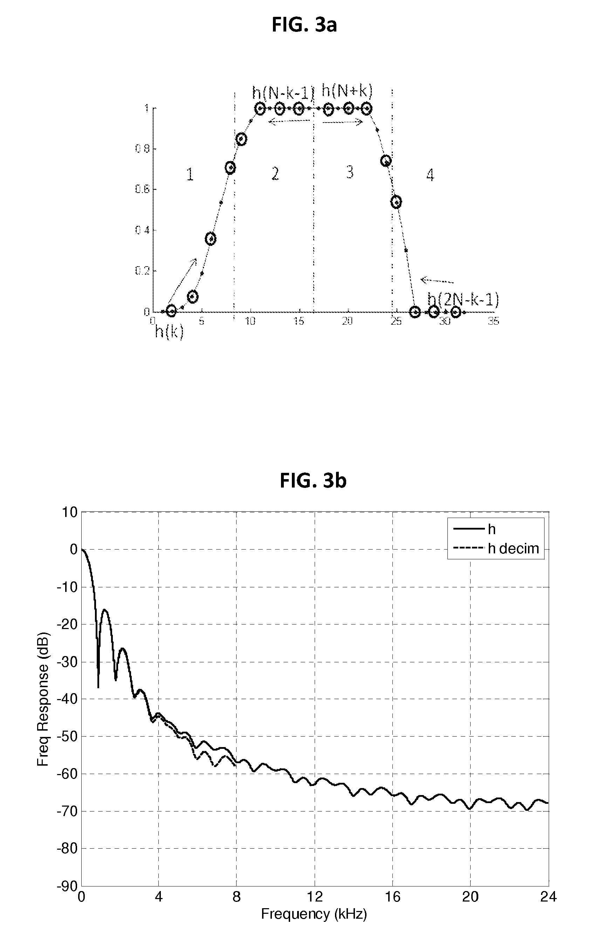

Les étapes mises en oeuvre par le bloc 102 seront détaillées ultérieurement en référence aux figures 2 et 3.

Le bloc 102 effectue également un repliement sur la trame pondérée suivant une transformation 2M vers M. Avantageusement, cette étape de repliement est effectuée en combinaison avec l'étape d'échantillonnage irrégulier et de décimation ou d'interpolation comme présenté ultérieurement.

Ainsi, à l'issue du bloc 102, le signal est sous forme de trame $T_M(t)$ de M échantillons. Une transformée de type DCT IV, par exemple, est ensuite appliquée par le bloc 103 pour obtenir des trames $T_M$ de taille M dans le domaine transformé, c'est-à-dire ici dans le domaine fréquentiel.

Ces trames sont ensuite quantifiées par le module de quantification 104 pour être transmises à un décodeur sous forme d'indice de quantification $I_Q$.

Le décodeur effectue une quantification inverse par le module 114 pour obtenir des trames $\widehat{T_M}$ dans le domaine transformé. Le module de transformation inverse 113 effectue par exemple une DCT IV inverse pour obtenir des trames $\widehat{T_M}(t)$ dans le domaine temporel.

Un dépliement de M vers 2M échantillons est ensuite effectué par le bloc 112 sur la trame $\widehat{T_M}(t)$. Une fenêtre de pondération de synthèse de taille 2M est obtenue par le bloc 112 par décimation ou interpolation à partir d'une fenêtre $h_s$ de taille 2N.

Dans le cas où N est supérieur à M, il s'agit d'une décimation et dans le cas où N est inférieur à M, il s'agit d'une interpolation.

Les étapes mises en oeuvre par le bloc 112 seront détaillées ultérieurement en référence aux figures 2 et 3.

Comme pour le codage, avantageusement, cette étape de dépliement est effectuée en combinaison avec l'étape d'échantillonnage irrégulier et de décimation ou d'interpolation et sera présentée ultérieurement.

Le flux audio décodé $\hat{X}(t)$ est alors synthétisé en sommant les parties en recouvrement au bloc 111.

Le bloc 102 ainsi que le bloc 112 sont maintenant décrit plus en détails.

Ces blocs effectuent les étapes d'échantillonnage irrégulier E10 pour définir une fenêtre adaptée à la taille M d'une transformée secondaire.

Ainsi, à partir d'un premier coefficient d (avec $0{\leq}d{<}N/M$) de la fenêtre stockée ($h_a$ ou $h_s$) de taille 2N, d'un ensemble défini de coefficients N-d-1, N+d, 2N-d-1, respectant une condition prédéterminée de reconstruction parfaite est sélectionné.

A partir de cet ensemble, une décimation ou une interpolation de ladite fenêtre est effectuée en E11 selon que N est supérieur ou inférieur à M, pour passer d'une fenêtre de 2N échantillons à une fenêtre de 2M échantillons.

Une condition prédéterminée de reconstruction parfaite est recherchée. Pour cela l'échantillonnage doit être effectuée de telle sorte que les équations suivantes soient respectées (assurant que les coefficients choisis pour la synthèse et l'analyse permettent la reconstruction parfaite pour une transformation de taille N):

$$\begin{bmatrix} h_a(N+k)h_s(N+k) + h_a(k)h_s(k) = 1 \\ h_a(N+k)h_s(2N-k-1) - h_a(k)h_s(N-1-k) = 0 \end{bmatrix}$$
$$k \in [0; N-1]$$

Ainsi, pour qu'une fenêtre décimée respecte les conditions de reconstruction parfaite de l'équation (3), à partir d'un point $h_a(k)$ (pour k € [0 ;2N-1]) sur la fenêtre d'analyse, seule la sélection supplémentaire des points $h_a(N+k)$ sur la fenêtre d'analyse et des points $h_s(k)$, $h_s(N+k)$, $h_s(2N-1-k)$ et $h_s(N-1-k)$ sur la fenêtre de synthèse conditionnent la reconstruction parfaite.

Cependant en ne conservant que ces 6 points, on observe qu'il existe alors une disparité, la fenêtre d'analyse est décimée par N et la fenêtre de synthèse par N/2.

De façon analogue, on remarque que si la décimation implique de sélectionner le point N-k-1 sur la fenêtre d'analyse $h_a(N-k-1)$, seule la sélection des points $h_a(2N-1-k)$ sur la fenêtre d'analyse et des 4 mêmes points $h_s(k)$, $h_s(N+k)$, $h_s(2N-1-k)$ et $h_s(N-1-k)$ sur la fenêtre de synthèse permet de respecter la condition de reconstruction parfaite.

Ainsi, lors d'une décimation telle qu'illustré en référence à la **figure 2**, pour respecter les conditions de reconstruction parfaite en (3), à partir d'un coefficient d pris pour 0<d<N/M, il faut obligatoirement que les coefficients suivants N-d-1, N+d, 2N-1-d sur la fenêtre d'analyse et d, N+d, 2N-1-d et N-1-d sur la fenêtre de synthèse soient également sélectionnés pour avoir une décimation de même taille entre la fenêtre d'analyse et la fenêtre de synthèse.

En effet, la condition de reconstruction parfaite ne s'applique qu'à des sous ensembles de 8 points indépendamment comme illustré sur la figure 2.

La sélection de l'ensemble défini de coefficients d, N-d-1, N+d, 2N-1-d sur la fenêtre d'analyse et sur la fenêtre de synthèse est ainsi effectuée.

La décimation s'effectue alors en conservant au minimum les coefficients de l'ensemble défini pour obtenir la fenêtre décimée, les autres coefficients pouvant être supprimés. On obtient ainsi la plus petite fenêtre décimée qui respecte les conditions de reconstruction parfaite.

Ainsi pour obtenir la plus petite fenêtre d'analyse décimée seuls les points $h_a(k)$, $h_a(N+k)$, $h_a(2N-1-k)$ et $h_a(N-1-k)$ sont gardés comme illustré dans l'exemple référencé en figure 2.

Pour la fenêtre de synthèse, le même ensemble de coefficients est sélectionné et la décimation s'effectue en conservant au minimum les coefficients de l'ensemble défini pour obtenir la fenêtre décimée.

Ainsi, pour obtenir la plus petite fenêtre de synthèse décimée, seuls les points $h_s(k)$, $h_s(N+k)$, $h_s(2N-1-k)$ et $h_s(N-1-k)$ sont gardés comme illustré dans l'exemple référencé en figure 2.

Compte tenu des symétries entre les points, dans le cas où la fenêtre de synthèse est le retourné temporel de la fenêtre d'analyse, seul un sous ensemble de 4 points (h(k), h(N+k), h(2N-1-k) et h(N-1-k)) est nécessaire à la décimation.

Ainsi, en sélectionnant l'ensemble défini ci-dessus, il est possible de décimer une fenêtre d'analyse et/ou de synthèse en choisissant n'importe quelles valeurs de k comprises entre 0 et N-1 tout en conservant les propriétés de reconstruction parfaite.

Une décimation adaptée permet de conserver au mieux la réponse en fréquence de la fenêtre à décimer.

Dans le cas d'une décimation adaptée, à une taille M de transformée, un coefficient sur N/M sur le premier quart de la fenêtre d'analyse (ou de synthèse) est pris et un deuxième ensemble de coefficients espacés d'un écart constant (de N/M) avec les coefficients de l'ensemble défini, est sélectionné. Ainsi, la décimation s'effectue en conservant en plus des coefficients d, N-1-d, N+d, 2N-1-d, les coefficients du deuxième ensemble pour obtenir la fenêtre décimée.

La figure 3 illustre un exemple d'échantillonnage irrégulier adaptée à une taille M de transformée. La fenêtre représentée étant séparée en quatre quarts.

Compte tenu des conditions de reconstruction parfaite, on obtient les équations suivantes pour l'obtention de la fenêtre décimée de taille 2M:

$$\text{pour } k \in [0; M/2-1]$$

$$\left[\begin{array}{l} h^*(k) = h\left(\left\lceil k\,\frac{N}{M}\right\rceil + d\right) \\ h^*(2M-k-1) = h\left(\left\lceil 2N-1-k\,\frac{N}{M}\right\rceil - d\right) \\ h^*(M+k) = h\left(\left\lceil N+k\,\frac{N}{M}\right\rceil + d\right) \\ h^*(M-k-1) = h\left(\left\lfloor N-1-k\,\frac{N}{M}\right\rfloor - d\right) \end{array}\right. \tag{7}$$

où h* est la fenêtre d'analyse ou de synthèse interpolée ou décimée, h est la fenêtre d'analyse ou de synthèse initiale, $\lfloor X \rfloor$ est l'entier le plus proche $\leq$ X, $\lceil X \rceil$ est l'entier le plus proche $\geq$ X. d est le décalage.

Le décalage est fonction de l'échantillon de départ d sur le premier quart de la fenêtre.

Ainsi, l'étape E10 du bloc 102 comporte la sélection d'un deuxième ensemble de coefficients espacés d'un écart constant (ici de N/M) à partir des coefficients de l'ensemble défini (d, N-d-1, N+d, 2N-d-1). Le même écart constant peut être appliqué pour sélectionner un troisième ensemble de coefficients.

En effet par exemple si l'on décime la fenêtre par 3, c'est-à-dire que N/M=3, l'écart est donc de 3 dans chaque portion de fenêtre. Si d=0 est le premier coefficient de l'ensemble défini, les coefficients d'un deuxième ou troisième ensemble espacés d'un écart constant sont alors 3 et 6, etc.

De même, si d=1, les premiers coefficients des deuxième ou troisième ensembles espacés d'un écart constant sont 1, 4, 7... ou encore les coefficients 2,5,8... pour d=2.

"d" dans l'équation 7 peut donc prendre les valeurs 0, 1 ou 2 (compris entre 0 et N/M-1 inclus).

La figure 3 représente le cas où le premier coefficient choisi dans le premier quart de la fenêtre est d=1.

Les coefficients des deuxième et troisième ensembles espacés d'un écart constant sont alors 4 et 7.

On illustre dans le tableau 1 suivant les points retenus pour le passage d'une transformée de taille N=48 vers des transformées de taille inférieure (M=24,16,12 et 8). On voit ainsi que pour implémenter la transformation de taille M=8, les échantillons 0, 6, 12,18,29, 35 ,41,47,48,54,60,66,77,83,89 et 95 sont considérés dans la fenêtre d'analyse ou de synthèse, montrant ainsi l'échantillonnage irrégulier.

**Tableau 1**

| indice | M=24; N/M=2 | M=16; N/M=3 | M=12; N/M=4 | M=8; N/M=6 | M=6; N/M=8 |
|---|---|---|---|---|---|
| 0 | 0 | 0 | 0 | 0 | 0 |
| 1 | 2 | 3 | 4 | 6 | 8 |
| 2 | 4 | 6 | 8 | 12 | 16 |
| 3 | 6 | 9 | 12 | 18 | 31 |
| 4 | 8 | 12 | 16 | 29 | 39 |
| 5 | 10 | 15 | 20 | 35 | 47 |
| 6 | 12 | 18 | 27 | 41 | 48 |
| 7 | 14 | 21 | 31 | 47 | 56 |
| 8 | 16 | 26 | 35 | 48 | 64 |
| 9 | 18 | 29 | 39 | 54 | 79 |
| 10 | 20 | 32 | 43 | 60 | 87 |
| 11 | 22 | 35 | 47 | 66 | 95 |
| 12 | 25 | 38 | 48 | 77 | |
| 13 | 27 | 41 | 52 | 83 | |

(suite)

| indice | M=24; N/M=2 | M=16; N/M=3 | M=12; N/M=4 | M=8; N/M=6 | M=6; N/M=8 |
|---|---|---|---|---|---|
| 14 | 29 | 44 | 56 | 89 | |
| 15 | 31 | 47 | 60 | 95 | |
| 16 | 33 | 48 | 64 | | |
| 17 | 35 | 51 | 68 | | |
| 18 | 37 | 54 | 75 | | |
| 19 | 39 | 57 | 79 | | |
| 20 | 41 | 60 | 83 | | |
| 21 | 43 | 63 | 87 | | |
| 22 | 45 | 66 | 91 | | |
| 23 | 47 | 69 | 95 | | |
| 24 | 48 | 74 | | | |
| 25 | 50 | 77 | | | |
| 26 | 52 | 80 | | | |
| 27 | 54 | 83 | | | |
| 28 | 56 | 86 | | | |
| 29 | 58 | 89 | | | |
| 30 | 60 | 92 | | | |
| 31 | 62 | 95 | | | |
| 32 | 64 | | | | |
| 33 | 66 | | | | |
| 34 | 68 | | | | |
| 35 | 70 | | | | |
| 36 | 73 | | | | |
| 37 | 75 | | | | |
| 38 | 77 | | | | |
| 39 | 79 | | | | |
| 40 | 81 | | | | |
| 41 | 83 | | | | |
| 42 | 85 | | | | |
| 43 | 87 | | | | |
| 44 | 89 | | | | |
| 45 | 91 | | | | |
| 46 | 93 | | | | |
| 47 | 95 | | | | |

On illustre dans le tableau 2 ci-dessous un mode de réalisation pour passer d'une fenêtre initiale prévue pour une transformée de taille N=48 à une fenêtre adaptée pour la réalisation d'une transformée de taille N=6. On a alors une décimation de N/M=8 et 7 possibilités pour la valeur de d : d=0...7. On indique dans le tableau les indices correspondant aux valeurs retenues dans la fenêtre initiale.

**Tableau 2**

| index | N/M=8, d=0 | N/M=8, d=1 | N/M=8, d=2 | N/M=8, d=3 | N/M=8, d=4 | N/M=8, d=5 | N/M=8, d=6 | N/M=8, d=7 |
|---|---|---|---|---|---|---|---|---|
| 0 | 0 | 1 | 2 | 3 | 4 | 5 | 6 | 7 |
| 1 | 8 | 9 | 10 | 11 | 12 | 13 | 14 | 15 |
| 2 | 16 | 17 | 18 | 19 | 20 | 21 | 22 | 23 |
| 3 | 31 | 30 | 29 | 28 | 27 | 26 | 25 | 24 |
| 4 | 39 | 38 | 37 | 36 | 35 | 34 | 33 | 32 |
| 5 | 47 | 46 | 45 | 44 | 43 | 42 | 41 | 40 |
| 6 | 48 | 49 | 50 | 51 | 52 | 53 | 54 | 55 |
| 7 | 56 | 57 | 58 | 59 | 60 | 61 | 62 | 63 |
| 8 | 64 | 65 | 66 | 67 | 68 | 69 | 70 | 71 |
| 9 | 79 | 78 | 77 | 76 | 75 | 74 | 73 | 72 |
| 10 | 87 | 86 | 85 | 84 | 83 | 82 | 81 | 80 |
| 11 | 95 | 94 | 93 | 92 | 91 | 90 | 89 | 88 |

De manière à avoir une réponse en fréquence plus proche de la fenêtre originale, l'invention propose de fixer la valeur à $d = \max\left(0, \left\lfloor 0.5\left(\frac{N}{M} - 1\right)\right\rfloor\right)$. Cette condition n'est pas limitative.

Si l'on considère que l'on part de la fin de chaque segment, l'équation 7 devient

$$\text{pour } k \in [0; M/2 - 1]$$
$$\begin{bmatrix} h^*(k) = h\left(\left\lceil k\frac{N}{M} \right\rceil + d\right) \\ h^*\left(\frac{3M}{2} + k\right) = h\left(\left\lfloor \frac{3N}{2} - 1 + (k+1)\frac{N}{M} \right\rfloor - d\right) \\ h^*\left(\frac{3M}{2} - k - 1\right) = h\left(\left\lceil \frac{3N}{2} - (k+1)\frac{N}{M} \right\rceil + d\right) \\ h^*(M - k - 1) = h\left(\left\lfloor N - 1 - k\frac{N}{M} \right\rfloor - d\right) \end{bmatrix} \quad (8)$$

Dans chaque portion on peut également, pour effectuer la transformation de taille M, choisir arbitrairement les points dans la fenêtre initiale de taille 2N. A partir d'un premier coefficient (h(d)) on peut prélever M/2-1 coefficients arbitrairement dans le premier quart de la fenêtre, aux indices $d_k$ à condition de sélectionner dans les trois autres portions les coefficients d'indice 2N-1- $d_k$ , N-1- $d_k$ et N+$d_k$. Cela est particulièrement avantageux pour améliorer la continuité ou la réponse fréquentielle de la fenêtre de taille 2M construite: les discontinuités peuvent être en particulier limitées par un choix judicieux des indices $d_k$.

On illustre dans le tableau 3 ci-dessous un mode particulier, avec 2N=48, 2M=16.

**Tableau 3**

| k | index |
|---|---|
| 0 | 1 |
| 1 | 5 |
| 2 | 11 |
| 3 | 19 |
| 4 | 28 |
| 5 | 36 |

(suite)

| k | index |
|---|---|
| 6 | 42 |
| 7 | 46 |
| 8 | 49 |
| 9 | 53 |
| 10 | 59 |
| 11 | 67 |
| 12 | 76 |
| 13 | 84 |
| 14 | 90 |
| 15 | 94 |

Dans un mode de réalisation avantageux, les blocs 102 et 112 effectuent les étapes d'échantillonnage en même temps que l'étape de repliement ou de dépliement des trames de signal.

Dans le cas décrit ici, une fenêtre de pondération d'analyse $h_a$ de taille 2N est appliquée à chaque trame de taille 2M en la décimant ou en l'interpolant à la volée dans le bloc 102.

Cette étape est réalisée en regroupant les équations (1) décrivant l'étape de repliement et les équations (7) décrivant une décimation régulière.

La trame pondérée est « repliée » suivant une transformation 2M vers M. Le « repliement » de la trame $T_{2M}$ de taille 2M pondérée par $h_a$ (de taille 2N) vers la trame $T_M$ de taille M peut par exemple être fait de la manière suivante :

$$\begin{bmatrix} T_M(k) = -T_{2M}\left(\frac{3M}{2}-k-1\right)h_a\left(\left\lceil\frac{3N}{2}-(k+1)\frac{N}{M}\right\rceil+d\right) - T_{2M}\left(\frac{3M}{2}+k\right)h_a\left(\left\lfloor\frac{3N}{2}-1+(k+1)\frac{N}{M}\right\rfloor-d\right) \\ T_M\left(M/2+k\right) = \ T_{2M}(k)h_a\left(\left\lceil k\frac{N}{M}\right\rceil+d\right) - T_{2M}(M-k-1)h_a\left(\left\lfloor N-1-k\frac{N}{M}\right\rfloor-d\right) \\ k\in[0;M/2-1] \end{bmatrix} \quad (9)$$

Ainsi, l'étape de décimation d'une fenêtre de taille 2N vers une fenêtre de taille 2M est faite en même temps que le repliement d'une trame de taille 2M vers une trame de taille M.

Les calculs effectués sont de même complexité que ceux utilisés pour un repliement classique, seuls les indices étant changés. Cette opération de décimation à la volée ne nécessite donc pas de complexité supplémentaire.

De même, au décodage, une fenêtre de pondération de synthèse $h_s$ de taille 2N est décimée à la volée dans le bloc 112, en une fenêtre de taille 2M pour être appliquée à chaque trame de taille 2M. Cette étape est réalisée en regroupant les équations (2) de dépliement avec les équations (7) ou (8) de décimation.

On obtient ainsi l'équation suivante:

$$\begin{bmatrix} T_{2M}^*(k) = T_M^*\left(\frac{M}{2}+k\right)h_s\left(\left\lceil k\frac{N}{M}\right\rceil+d\right) \\ T_{2M}^*\left(\frac{M}{2}+k\right) = -T_M^*(M-k-1)h_s\left(\left\lfloor\frac{N}{2}-1+(k+1)\frac{N}{M}\right\rfloor-d\right) \\ T_{2M}^*(M+k) = -T_M^*\left(\frac{M}{2}-k-1\right)h_s\left(\left\lceil N+k\frac{N}{M}\right\rceil+d\right) \\ T_{2M}^*\left(\frac{3M}{2}+k\right) = -T_M^*(k)h_s\left(\left\lfloor\frac{3N}{2}-1+(k+1)\frac{N}{M}\right\rfloor-d\right) \\ k\in[0;N/2-1] \end{bmatrix} \quad (10)$$

Là aussi, ces équations n'entrainent pas de complexité supplémentaire par rapport aux équations de dépliement classiques. Elles permettent d'obtenir une décimation de fenêtre à la volée sans avoir de pré-calculs à effectuer et sans avoir à stocker de fenêtres supplémentaires.

Dans le cas où la fenêtre de synthèse est le retourné temporel de la fenêtre d'analyse ($h_s(k)=h_a(2N-1-k)$), et que le rapport N/M est un entier (donc uniquement une décimation), les équations 10 deviennent :

$$\left[\begin{array}{l} T_{2M}^{*}\left(k\right)=T_{M}^{*}\left(\tfrac{M}{2}+k\right)h_{s}\left(\left(2M-k\right)\tfrac{N}{M}-1-d\right) \\ T_{2M}^{*}\left(\tfrac{M}{2}+k\right)=-T_{M}^{*}\left(M-k-1\right)h_{s}\left(\left(\tfrac{3M}{2}-k-1\right)\tfrac{N}{M}+d\right) \\ T_{2M}^{*}\left(M+k\right)=-T_{M}^{*}\left(\tfrac{M}{2}-k-1\right)h_{s}\left(\left(M-k\right)\tfrac{N}{M}-1-d\right) \\ T_{2M}^{*}\left(\tfrac{3M}{2}+k\right)=-T_{M}^{*}\left(k\right)h_{s}\left(\left(\tfrac{M}{2}-k-1\right)\tfrac{N}{M}+d\right) \end{array}\right. \qquad (11)$$

$$k \in [0; N/2-1]$$

Ce mode de réalisation permet de n'avoir en mémoire qu'une seule fenêtre utilisée à la fois pour l'analyse et la synthèse.

On a donc montré que les étapes de repliement/dépliement et de décimation peuvent être combinées afin de réaliser une transformation de taille M en utilisant une fenêtre d'analyse/synthèse prévue pour une taille N. On obtient grâce à l'invention une complexité identique à l'application d'une transformation de taille M avec une fenêtre d'analyse/synthèse prévue pour une taille M, ce sans utilisation de mémoire complémentaire. Notons que cet effet est révélé pour une implémentation efficace de la transformation MDCT basée sur une DCT IV (comme suggéré dans H. S. Malvar, Signal Processing with Lapped Transforms, Artech House, 1992), cet effet pourrait également être mis en lumière avec d'autres implémentations efficaces notamment celle proposée par Duhamel et al. dans "A fast algorithm for the implementation of filter banks based on TDAC" présenté à la conférence ICASSP91).

Cette méthode n'est pas limitative, elle peut être adaptée notamment dans le cas où la fenêtre d'analyse présente des 0 et où elle s'applique à la trame en décalage (les échantillons sonores les plus récents sont pondérés par la portion de fenêtre juste avant la portion présentant des zéros) pour réduire le délai de codage. Dans ce cas, les indices affecté aux trames et ceux affectés aux fenêtres sont décalés.

Dans un mode de réalisation particulier, on décrit à présent une méthode d'interpolation dans le cas où on dispose d'une fenêtre h de taille 2N et que l'on a des trames de taille M.

Dans le cas où N est inférieur à M, une même sélection d'un ensemble de coefficients respectant les conditions de reconstruction parfaite est aussi effectuée. Un ensemble de coefficients adjacents aux coefficients de l'ensemble défini est aussi déterminé. L'interpolation s'effectuant alors en insérant un coefficient entre chacun des coefficients de l'ensemble coefficients définis et chacun des coefficients d'un ensemble de coefficients adjacents pour obtenir la fenêtre interpolée.

Ainsi, pour respecter les conditions de reconstruction parfaite définis par l'équation (3), si l'on veut insérer un échantillon entre les positions k et k+1, on propose d'insérer des points entre les positions $h_a(k)$ et $h_a(k+1)$, $h_a(N-k-1)$ et $h_a(N-k-2)$, $h_a(N+k)$ et $h_a(N+k+1)$, $h_a(2N-1-k)$ et $h_a(2N-k-2)$ sur la fenêtre d'analyse et des points entre les positions $h_s(k)$ et $h_s(k+1)$, $h_s(N+k)$ et $h_s(N+k+1)$, $h_s(2N-1-k)$ et $h_s(2N-k-2)$, $h_s(N-1-k)$ et $h_s(N-k-2)$ sur la fenêtre de synthèse. Les 8 nouveaux points insérés respectent aussi les conditions de reconstruction parfaite de l'équation (3).

Dans un premier mode de réalisation, l'interpolation est réalisée par la répétition d'un coefficient de l'ensemble défini ou de l'ensemble de coefficients adjacents.

Dans un second mode de réalisation, l'interpolation est réalisée par le calcul d'un coefficient (hcomp) en vue d'obtenir une meilleure réponse fréquentielle pour la fenêtre obtenue.

Pour cela, une première étape de calcul d'une fenêtre de complément $h_{init}$ de taille 2N est effectuée. Cette fenêtre est une version interpolée entre les coefficients de h de taille 2N, telle que:

$$\left\{\begin{array}{l} h_{init}(k)=\left(h(k-1)+h(k)\right)/2 \quad \text{pour } k \in [1; 2N-1] \\ h_{init}(0)=h(0)/2 \end{array}\right. \qquad (12)$$

Dans une deuxième étape, la fenêtre hcomp est calculée selon EP 2319039 pour qu'elle soit à reconstruction parfaite. Pour cela, la fenêtre est calculée sur les coefficients de l'ensemble défini selon les équations suivantes:

$$\begin{cases} hcomp(k) = \dfrac{h_{init}(k)}{\sqrt{h_{init}\left(N+k\right)^2 + h_{init}\left(k\right)^2}} \quad \text{pour } k \in [1;N-1] \\[6mm] hcomp(k+N) = \dfrac{hcomp(k+N)}{\sqrt{h_{init}\left(N+k\right)^2 + h_{init}\left(k\right)^2}} \quad \text{pour } k \in [1;N-1] \end{cases} \qquad (13)$$

Cette fenêtre est soit calculée à l'initialisation, soit stockée en ROM.

Les étapes d'interpolation et de décimation peuvent être intégrées pour présenter un mode de réalisation dans lequel on applique efficacement une transformation.

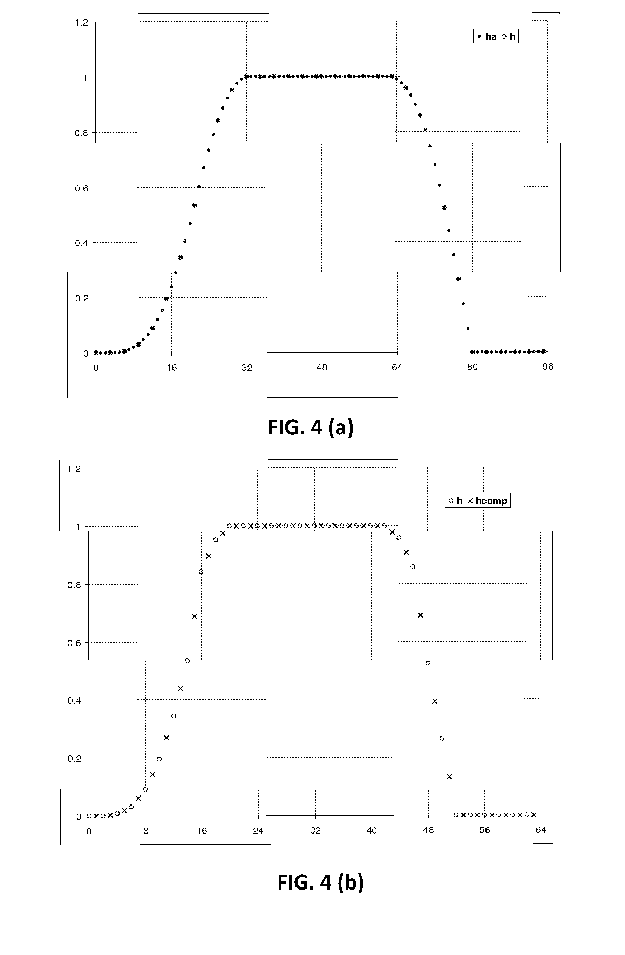

En référence aux figures 4(a) et 4(b), ce mode de réalisation est illustré.

Il est décomposé en deux étapes :

- dans une première étape illustrée à la figure **4(a)**, on part d'une fenêtre $h_a$ de taille 2N pour obtenir une seconde fenêtre h de taille 2N' (ici 2N=96 et 2N'=32, c'est-à-dire qu'une décimation d'un facteur 3 est réalisé). Cette décimation est irrégulière et conforme au à l'équation (7).
- dans une seconde étape illustrée à la figure 4(b), on adjoint aux 2N' coefficients de h, un ensemble de coefficients complémentaires hcomp pour obtenir au total 2M coefficients (ici le nombre de coefficients complémentaire est 2N', on obtient donc 2M=4N').

Sur l'exemple particulier aux figures 4(a) et 4(b), on a réalisé la conversion d'une fenêtre initiale de taille 2N=96 prévue pour une MDCT de taille N=48 vers une fenêtre destinée à implémenter une MDCT de taille M=32, en construisant une fenêtre de taille 2M=64.

Au moment de la transformation, dans le bloc 102, la fenêtre h et la fenêtre hcomp sont appliquées alternativement en respectant les équations suivantes:

$$\begin{cases} T_M(k+1) = -T_{2M}\left(\tfrac{3M}{2}-(k+1)-1\right)h\left(\tfrac{3N}{2}-k/2-1\right) - T_{2M}\left(\tfrac{3M}{2}+k+1\right)h\left(\tfrac{3N}{2}+k/2\right) \\[3mm] T_M(k) = -T_{2M}\left(\tfrac{3N}{2}-k-1\right)hcomp\left(\tfrac{3N}{2}-k/2-1\right) - T_{2M}\left(\tfrac{3N}{2}+k\right)hcomp\left(\tfrac{3N}{2}+k/2\right) \\[3mm] T_M(N/2+k) = T_{2M}(k)h(k/2) - T_{2M}(N-k-1)h(N-k/2-1) \\[3mm] T_M(N/2+k+1) = T_{2M}(k+1)hcomp(k/2) - T_{2M}(N-(k+1)-1)hcomp(N-k/2-1) \end{cases}$$

$$(14)$$

De même, au moment de la transformation inverse dans le bloc 112, la fenêtre h puis la fenêtre hcomp sont appliqués alternativement selon les équations:

$$\begin{cases} T_{2M}^*(k) = T_M^*\left(\tfrac{N}{2}+k\right)h(2N-k/2-1) \\[3mm] T_{2M}^*(k+1) = T_M^*\left(\tfrac{N}{2}+k+1\right)hcomp(2N-k/2-1) \\[3mm] T_{2M}^*\left(\tfrac{N}{2}+k+1\right) = -T_M^*(N-(k+1)-1)h\left(\tfrac{3N}{2}-k/2-1\right) \\[3mm] T_{2M}^*\left(\tfrac{N}{2}+k\right) = -T_M^*(N-k-1)hcomp\left(\tfrac{3N}{2}-k/2-1\right) \\[3mm] T_{2M}^*(N+k) = -T_M^*\left(\tfrac{N}{2}-k-1\right)h(N-k/2-1) \\[3mm] T_{2M}^*(N+k+1) = -T_M^*\left(\tfrac{N}{2}-(k+1)-1\right)hcomp(N-k/2-1) \\[3mm] T_{2M}^*\left(\tfrac{3N}{2}+k+1\right) = -T_M^*(k+1)h\left(\tfrac{N}{2}-k/2-1\right) \\[3mm] T_{2M}^*\left(\tfrac{3N}{2}+k\right) = -T_M^*(k)hcomp\left(\tfrac{N}{2}-k/2-1\right) \end{cases} \qquad (15)$$

$$k/2 \in [0; N/2-1]$$

De nombreuses déclinaisons sont possibles selon l'invention. Ainsi, à partir d'une seule fenêtre stockée en mémoire, il est possible d'obtenir une fenêtre de taille différente, soit par interpolation, soit par décimation ou soit par interpolation d'une fenêtre décimée ou inversement.

La flexibilité du codage et du décodage est donc grande sans pour autant augmenter la place mémoire ou les calculs à effectuer.

La mise en oeuvre de la décimation ou de l'interpolation lors du repliement ou du dépliement de la MDCT apporte un gain supplémentaire en complexité et en flexibilité.

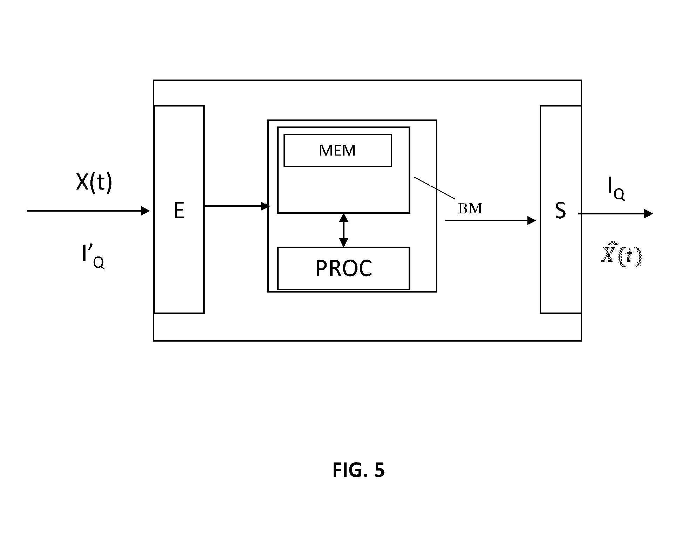

La **figure 5** représente une réalisation matérielle d'un dispositif de codage ou de décodage selon l'invention. Ce dispositif comporte un processeur PROC coopérant avec un bloc mémoire BM comportant une mémoire de stockage et/ou de travail MEM.

Le bloc mémoire peut avantageusement comporter un programme informatique comportant des instructions de code pour la mise en oeuvre des étapes du procédé de codage ou de décodage au sens de l'invention, lorsque ces instructions sont exécutées par le processeur PROC, et notamment un échantillonnage irrégulier d'une fenêtre initiale prévue pour une transformée de taille initiale N donnée, pour appliquer une transformation secondaire de taille M différente de N.

Typiquement, la description de la figure 1 reprend les étapes d'un algorithme d'un tel programme informatique. Le programme informatique peut également être stocké sur un support mémoire lisible par un lecteur du dispositif ou téléchargeable dans l'espace mémoire de celui-ci.

Un tel équipement comporte un module d'entrée apte à recevoir un flux audio X(t) dans le cas du codeur ou des indices de quantification $I_Q$ dans le cas d'un décodeur.

Le dispositif comporte un module de sortie apte à transmettre des indices de quantification $I_Q$ dans le cas d'un codeur ou le flux décodé $\hat{X}(t)$ dans le cas du décodeur.

Dans un mode possible de réalisation, le dispositif ainsi décrit peut comporter à la fois les fonctions de codage et de décodage.

## Revendications

**1.** Procédé de codage ou de décodage par transformée d'un signal audionumérique utilisant des fenêtres de pondération d'analyse ($h_a$) ou de synthèse ($h_s$) appliquées à des trames d'échantillons, **caractérisé en ce qu'**il comporte un échantillonnage irrégulier (E10) d'une fenêtre initiale prévue pour une transformée de taille initiale N donnée, pour appliquer une transformation secondaire de taille M différente de N, l'étape d'échantillonnage comportant la sélection à partir d'un premier coefficient d de la fenêtre initiale avec 0≤d<N/M, d'un ensemble défini de coefficients N-d-1, N+d, 2N-d-1, respectant une condition prédéterminée de reconstruction parfaite.

**2.** Procédé selon la revendication 1, **caractérisé en ce que** lorsque N est supérieur à M, une décimation de la fenêtre initiale s'effectue en conservant au minimum les coefficients de l'ensemble défini pour obtenir une fenêtre décimée.

**3.** Procédé selon la revendication 2, **caractérisé en ce qu'**il comporte la sélection d'un deuxième ensemble de coefficients espacés d'un écart constant avec les coefficients de l'ensemble défini et **en ce que** la décimation s'effectue en conservant en outre les coefficients du deuxième ensemble pour obtenir la fenêtre décimée.

**4.** Procédé selon la revendication 3, **caractérisé en ce que** la décimation d'une fenêtre de taille 2N en une fenêtre de taille 2M s'effectue selon les équations suivantes:

$$\text{pour } k \in [0; M/2 - 1]$$
$$\left[ \begin{array}{l} h^*(k) = h\left(\left\lceil k\frac{N}{M} \right\rceil + d\right) \\ h^*(2M - k - 1) = h\left(\left\lfloor 2N - 1 - k\frac{N}{M} \right\rfloor - d\right) \\ h^*(M + k) = h\left(\left\lceil N + k\frac{N}{M} \right\rceil + d\right) \\ h^*(M - k - 1) = h\left(\left\lfloor N - 1 - k\frac{N}{M} \right\rfloor - d\right) \end{array} \right.$$

où h* est la fenêtre d'analyse ou de synthèse décimée, h est la fenêtre d'analyse ou de synthèse initiale, ⌊X⌋ est l'entier le plus proche ≤ X, ⌈X⌉ est l'entier le plus proche ≥ X et d est la valeur du premier coefficient de l'ensemble défini.

5. Procédé selon la revendication 1, **caractérisé en ce que** lorsque N est inférieur à M, une interpolation s'effectue en insérant un coefficient entre chacun des coefficients de l'ensemble de coefficients définis et chacun des coefficients d'un ensemble de coefficients adjacents pour obtenir une fenêtre interpolée.

6. Procédé selon la revendication 5, **caractérisé en ce qu'**il comporte la sélection d'un deuxième ensemble de coefficients espacés d'un écart constant avec les coefficients de l'ensemble défini et **en ce que** l'interpolation s'effectue en insérant en outre un coefficient entre chacun des coefficients du deuxième ensemble et chacun des coefficients d'un ensemble de coefficients adjacents pour obtenir la fenêtre interpolée.

7. Procédé selon l'une des revendications 5 à 6, **caractérisé en ce qu'**il comporte le calcul d'une fenêtre complémentaire comportant des coefficients calculés à partir des coefficients de l'ensemble définis et des coefficients adjacents, pour interpoler ladite fenêtre.

8. Procédé selon l'une quelconque des revendications 1 à 7, **caractérisé en ce que** l'étape d'échantillonnage irrégulier et une décimation ou interpolation de la fenêtre initiale sont effectuées lors de l'étape de mise en oeuvre du repliement ou du dépliement temporel utilisé pour le calcul de la transformée secondaire.

9. Procédé selon l'une quelconque des revendications 1 à 7, **caractérisé en ce que** à la fois une décimation et une interpolation de la fenêtre initiale sont effectuées lors de l'étape de mise en oeuvre du repliement ou du dépliement temporel utilisé pour le calcul de la transformée secondaire.

10. Procédé selon la revendication 8, **caractérisé en ce que** la décimation lors du repliement temporel s'effectue selon l'équation suivante:

$$\begin{bmatrix} T_M(k) = -T_{2M}\left(\frac{3M}{2}-k-1\right)h_a\left(\left\lceil\frac{3N}{2}-(k+1)\frac{N}{M}\right\rceil+d\right) - T_{2M}\left(\frac{3M}{2}+k\right)h_a\left(\left\lfloor\frac{3N}{2}-1+(k+1)\frac{N}{M}\right\rfloor-d\right) \\ T_M(M/2+k) = T_{2M}(k)h_a\left(\left\lceil k\frac{N}{M}\right\rceil+d\right) - T_{2M}(M-k-1)h_a\left(\left\lfloor N-1-k\frac{N}{M}\right\rfloor-d\right) \end{bmatrix}$$
$$k \in [0; M/2-1]$$

avec $T_M$ une trame de M échantillons, $T_{2M}$, une trame de 2M échantillons.

11. Procédé selon la revendication 8, **caractérisé en ce que** la décimation lors du dépliement temporel s'effectue selon l'équation suivante:

$$\begin{bmatrix} T_{2M}^*(k) = T_M^*\left(\frac{M}{2}+k\right)h_s\left(\left\lceil k\frac{N}{M}\right\rceil+d\right) \\ T_{2M}^*\left(\frac{M}{2}+k\right) = -T_M^*(M-k-1)h_s\left(\left\lfloor\frac{N}{2}-1+(k+1)\frac{N}{M}\right\rfloor-d\right) \\ T_{2M}^*(M+k) = -T_M^*\left(\frac{M}{2}-k-1\right)h_s\left(\left\lceil N+k\frac{N}{M}\right\rceil+d\right) \\ T_{2M}^*\left(\frac{3M}{2}+k\right) = -T_M^*(k)h_s\left(\left\lfloor\frac{3N}{2}-1+(k+1)\frac{N}{M}\right\rfloor-d\right) \end{bmatrix}$$
$$k \in [0; N/2-1]$$

avec $T_M^*$ une trame de M échantillons, $T_{2M}^*$, une trame de 2M échantillons.

12. Procédé selon les revendications 7 et 9, **caractérisé en ce que** lorsque la transformée secondaire est de taille M=3/2N, une décimation de la fenêtre initiale puis une interpolation est effectuée lors du repliement temporel selon les équations suivantes:

$$\left[\begin{array}{l} T_M(k+1) = -T_{2M}\left(\frac{3M}{2}-(k+1)-1\right)h\left(\frac{3N}{2}-k/2-1\right) - T_{2M}\left(\frac{3M}{2}+k+1\right)h\left(\frac{3N}{2}+k/2\right) \\ T_M(k) = -T_{2M}\left(\frac{3N}{2}-k-1\right)hcomp\left(\frac{3N}{2}-k/2-1\right) - T_{2M}\left(\frac{3N}{2}+k\right)hcomp\left(\frac{3N}{2}+k/2\right) \\ T_M(N/2+k) = T_{2M}(k)h(k/2) - T_{2M}(N-k-1)h(N-k/2-1) \\ T_M(N/2+k+1) = T_{2M}(k+1)hcomp(k/2) - T_{2M}(N-(k+1)-1)hcomp(N-k/2-1) \end{array}\right.$$

$$k/2 \in [0; N/2-1]$$

avec $T_M$ une trame de M échantillons, $T_{2M}$, une trame de 2M échantillons, hcomp la fenêtre complémentaire.

**13.** Procédé selon les revendications 7 et 9, **caractérisé en ce que** lorsque la transformée secondaire est de taille M=3/2N, une décimation de la fenêtre initiale puis une interpolation est effectuée lors du dépliement temporel selon les équations suivantes:

$$\left[\begin{array}{l} T_{2M}^*(k) = T_M^*\left(\frac{N}{2}+k\right)h(2N-k/2-1) \\ T_{2M}^*(k+1) = T_M^*\left(\frac{N}{2}+k+1\right)hcomp(2N-k/2-1) \\ T_{2M}^*\left(\frac{N}{2}+k+1\right) = -T_M^*(N-(k+1)-1)h\left(\frac{3N}{2}-k/2-1\right) \\ T_{2M}^*\left(\frac{N}{2}+k\right) = -T_M^*(N-k-1)hcomp\left(\frac{3N}{2}-k/2-1\right) \\ T_{2M}^*(N+k) = -T_M^*\left(\frac{N}{2}-k-1\right)h(N-k/2-1) \\ T_{2M}^*(N+k+1) = -T_M^*\left(\frac{N}{2}-(k+1)-1\right)hcomp(N-k/2-1) \\ T_{2M}^*\left(\frac{3N}{2}+k+1\right) = -T_M^*(k+1)h\left(\frac{N}{2}-k/2-1\right) \\ T_{2M}^*\left(\frac{3N}{2}+k\right) = -T_M^*(k)hcomp\left(\frac{N}{2}-k/2-1\right) \end{array}\right.$$

$$k/2 \in [0; N/2-1]$$

avec $T_M$ une trame de M échantillons, $T_{2M}$, une trame de 2M échantillons, hcomp la fenêtre complémentaire.

**14.** Dispositif de codage ou de décodage par transformée d'un signal audionumérique utilisant des fenêtres de pondération d'analyse ($h_a$) ou de synthèse ($h_s$) appliquées à des trames d'échantillons, **caractérisé en ce qu'**il comporte un module d'échantillonnage (102, 112) configuré pour échantillonner de manière irrégulière, une fenêtre initiale prévue pour une transformée de taille initiale N donnée, pour appliquer une transformation secondaire de taille M différente de N, l'échantillonnage comportant la sélection à partir d'un premier coefficient d de la fenêtre initiale avec $0 \le d < N/M$, d'un ensemble défini de coefficients N-d-1, N+d, 2N-d-1, respectant une condition prédéterminée de reconstruction parfaite.

**15.** Programme informatique comportant des instructions de code pour la mise en oeuvre des étapes du procédé de codage ou de décodage selon l'une des revendications 1 à 13, lorsque ces instructions sont exécutées par un processeur.

**Patentansprüche**

**1.** Verfahren zur Transformationscodierung oder -decodierung eines audiodigitalen Signals, das Analysegewichtungsfenster ($h_a$) oder Synthesegewichtungsfenster ($h_s$) verwendet, die an Musterraster angelegt werden, **dadurch gekennzeichnet, dass** es eine unregelmäßige Bemusterung (E10) eines Ausgangsfensters umfasst, das für eine Transformation von gegebener Ausgangsgröße N vorgesehen ist, um eine Sekundärtransformation der Größe M, unterschiedlich zu N, anzulegen, wobei der Schritt der Bemusterung die Auswahl aus einem ersten Koeffizienten d des Ausgangsfensters, wobei $0 \le d < N/M$, einer definierten Gesamtheit von Koeffizienten N-d-1, N+d, 2N-d-1 umfasst, wobei eine vorbestimmte Bedingung einer perfekten Rekonstruktion eingehalten wird.

2. Verfahren nach Anspruch 1, **dadurch gekennzeichnet, dass**, wenn N größer als M ist, eine Dezimierung des Ausgangsfensters erfolgt, wobei mindestens die Koeffizienten der definierten Gesamtheit beibehalten werden, um ein dezimiertes Fenster zu erhalten.

3. Verfahren nach Anspruch 2, **dadurch gekennzeichnet, dass** es die Auswahl einer zweiten Gesamtheit von Koeffizienten umfasst, die um einen konstanten Abstand mit den Koeffizienten der definierten Gesamtheit beabstandet sind, und dass die Dezimierung ferner unter Beibehaltung der Koeffizienten der zweiten Gesamtheit erfolgt, um das dezimierte Fenster zu erhalten.

4. Verfahren nach Anspruch 3, **dadurch gekennzeichnet, dass** die Dezimierung eines Fensters der Größe 2N zu einem Fenster der Größe 2M nach folgenden Gleichungen erfolgt:

für k∈[0;M/2-1]

$$\left[\begin{array}{l} h^{*}(k) = h\left(\left\lceil k\frac{N}{M}\right\rceil + d\right) \\ h^{*}(2M - k - 1) = h\left(\left\lfloor 2N - 1 - k\frac{N}{M}\right\rfloor - d\right) \\ h^{*}(M + k) = h\left(\left\lceil N + k\frac{N}{M}\right\rceil + d\right) \\ h^{*}(M - k - 1) = h\left(\left\lfloor N - 1 - k\frac{N}{M}\right\rfloor - d\right) \end{array}\right.$$

wobei h\* das dezimierte Analyse- oder Synthesefenster ist, h das Analyse- oder Syntheseausgangsfenster ist, ⌊X⌋ die nächste ganze Zahl ≤ X ist, ⌈X⌉ die nächste ganze Zahl ≥ X ist und d der Wert des ersten Koeffizienten der definierten Gesamtheit ist.

5. Verfahren nach Anspruch 1, **dadurch gekennzeichnet, dass**, wenn N kleiner als M ist, eine Interpolation erfolgt, wobei ein Koeffizient zwischen jeden der Koeffizienten der Gesamtheit von definierten Koeffizienten und jeden der Koeffizienten einer Gesamtheit von angrenzenden Koeffizienten eingesetzt wird, um ein interpoliertes Fenster zu erhalten.

6. Verfahren nach Anspruch 5, **dadurch gekennzeichnet, dass** es die Auswahl einer zweiten Gesamtheit von Koeffizienten umfasst, die um einen konstanten Abstand mit den Koeffizienten der definierten Gesamtheit beabstandet sind, und dass die Interpolation erfolgt, wobei ferner ein Koeffizient zwischen jeden der Koeffizienten der zweiten Gesamtheit und jeden der Koeffizienten einer Gesamtheit von angrenzenden Koeffizienten eingesetzt wird, um das interpolierte Fenster zu erhalten.

7. Verfahren nach einem der Ansprüche 5 bis 6, **dadurch gekennzeichnet, dass** es die Berechnung eines komplementären Fensters aufweist, umfassend Koeffizienten, die aus definierten Koeffizienten der Gesamtheit und angrenzenden Koeffizienten berechnet werden, um das Fenster zu interpolieren.

8. Verfahren nach einem der Ansprüche 1 bis 7, **dadurch gekennzeichnet, dass** der Schritt der unregelmäßigen Bemusterung und eine Dezimierung oder Interpolation des Ausgangsfensters in dem Schritt des Einsatzes des zeitlichen Zurückziehens oder Erweiterns, der für die Berechnung der sekundären Transformation verwendet wird, durchgeführt werden.

9. Verfahren nach einem der Ansprüche 1 bis 7, **dadurch gekennzeichnet, dass** sowohl eine Dezimierung als auch eine Interpolation des Ausgangsfensters in dem Schritt des Einsatzes des zeitlichen Zurückziehens oder Erweiterns, der für die Berechnung der sekundären Transformation verwendet wird, durchgeführt werden.

10. Verfahren nach Anspruch 8, **dadurch gekennzeichnet, dass** die Dezimierung beim zeitlichen Zurückziehen nach folgender Gleichung erfolgt:

$$\left[\begin{array}{l} T_M(k) = -T_{2M}\left(\frac{3M}{2}-k-1\right)h_a\left(\left\lceil\frac{3N}{2}-(k+1)\frac{N}{M}\right\rceil+d\right)-T_{2M}\left(\frac{3M}{2}+k\right)h_a\left(\left\lfloor\frac{3N}{2}-1+(k+1)\frac{N}{M}\right\rfloor-d\right) \\ T_M(M/2+k) = T_{2M}(k)h_a\left(\left\lceil k\frac{N}{M}\right\rceil+d\right)-T_{2M}(M-k-1)h_a\left(\left\lfloor N-1-k\frac{N}{M}\right\rfloor-d\right) \end{array}\right.$$

$$k \in [0; M/2-1]$$

wobei $T_M$ ein Raster von M Mustern ist, $T_{2M}$ ein Raster von 2M Mustern ist.

**11.** Verfahren nach Anspruch 8, **dadurch gekennzeichnet, dass** die Dezimierung beim zeitlichen Erweitern nach folgender Gleichung erfolgt:

$$\left[\begin{array}{l} T_{2M}^*(k) = T_M^*\left(\frac{M}{2}+k\right)h_s\left(\left\lceil k\frac{N}{M}\right\rceil+d\right) \\ T_{2M}^*\left(\frac{M}{2}+k\right) = -T_M^*(M-k-1)h_s\left(\left\lfloor\frac{N}{2}-1+(k+1)\frac{N}{M}\right\rfloor-d\right) \\ T_{2M}^*(M+k) = -T_M^*\left(\frac{M}{2}-k-1\right)h_s\left(\left\lceil N+k\frac{N}{M}\right\rceil+d\right) \\ T_{2M}^*\left(\frac{3M}{2}+k\right) = -T_M^*(k)h_s\left(\left\lfloor\frac{3N}{2}-1+(k+1)\frac{N}{M}\right\rfloor-d\right) \end{array}\right.$$

$$k \in [0; N/2-1]$$

wobei $T_M^*$ ein Raster von M Mustern ist, $T_{2M}^*$ ein Raster von 2M Mustern ist.

**12.** Verfahren nach den Ansprüchen 7 und 9, **dadurch gekennzeichnet, dass**, wenn die sekundäre Transformation eine Größe M=3/2N hat, eine Dezimierung des Ausgangsfensters und dann eine Interpolation beim zeitlichen Zurückziehen nach folgenden Gleichungen durchgeführt werden:

$$\left[\begin{array}{l} T_M(k+1) = -T_{2M}\left(\frac{3M}{2}-(k+1)-1\right)h\left(\frac{3N}{2}-k/2-1\right)-T_{2M}\left(\frac{3M}{2}+k+1\right)h\left(\frac{3N}{2}+k/2\right) \\ T_M(k) = -T_{2M}\left(\frac{3N}{2}-k-1\right)hcomp\left(\frac{3N}{2}-k/2-1\right)-T_{2M}\left(\frac{3N}{2}+k\right)hcomp\left(\frac{3N}{2}+k/2\right) \\ T_M(N/2+k) = T_{2M}(k)h(k/2)-T_{2M}(N-k-1)h(N-k/2-1) \\ T_M(N/2+k+1) = T_{2M}(k+1)hcomp(k/2)-T_{2M}(N-(k+1)-1)hcomp(N-k/2-1) \end{array}\right.$$

$$k/2 \in [0; N/2-1]$$

wobei $T_M$ ein Raster von M Mustern ist, $T_{2M}$ ein Raster von 2M Mustern ist, hcomp das komplementäre Fenster ist.

**13.** Verfahren nach den Ansprüchen 7 und 9, **dadurch gekennzeichnet, dass**, wenn die sekundäre Transformation eine Größe M=3/2N hat, eine Dezimierung des Ausgangsfensters und dann eine Interpolation beim zeitlichen Erweitern nach folgenden Gleichungen durchgeführt werden:

$$\left[\begin{array}{l} T_{2M}^{*}(k) = T_{M}^{*}\left(\frac{N}{2}+k\right)h(2N-k/2-1) \\ T_{2M}^{*}(k+1) = T_{M}^{*}\left(\frac{N}{2}+k+1\right)hcomp(2N-k/2-1) \\ T_{2M}^{*}\left(\frac{N}{2}+k+1\right) = -T_{M}^{*}(N-(k+1)-1)h\left(\frac{3N}{2}-k/2-1\right) \\ T_{2M}^{*}\left(\frac{N}{2}+k\right) = -T_{M}^{*}(N-k-1)hcomp\left(\frac{3N}{2}-k/2-1\right) \\ T_{2M}^{*}(N+k) = -T_{M}^{*}\left(\frac{N}{2}-k-1\right)h(N-k/2-1) \\ T_{2M}^{*}(N+k+1) = -T_{M}^{*}\left(\frac{N}{2}-(k+1)-1\right)hcomp(N-k/2-1) \\ T_{2M}^{*}\left(\frac{3N}{2}+k+1\right) = -T_{M}^{*}(k+1)h\left(\frac{N}{2}-k/2-1\right) \\ T_{2M}^{*}\left(\frac{3N}{2}+k\right) = -T_{M}^{*}(k)hcomp\left(\frac{N}{2}-k/2-1\right) \end{array}\right.$$

$$k/2 \in [0; N/2-1]$$

wobei $T_M$ ein Raster von M Mustern ist, $T_{2M}$ ein Raster von 2M Mustern ist, hcomp das komplementäre Fenster ist.

**14.** Vorrichtung zur Transformationscodierung oder -decodierung eines audiodigitalen Signals, das Analysegewichtungsfenster ($h_a$) oder Synthesegewichtungsfenster ($h_s$) verwendet, die an Musterraster angelegt werden, **dadurch gekennzeichnet, dass** es ein Bemusterungsmodul (102, 112) umfasst, das für eine unregelmäßige Bemusterung eines Ausgangsfensters ausgeführt ist, das für eine Transformation von gegebener Ausgangsgröße N vorgesehen ist, um eine Sekundärtransformation der Größe M, unterschiedlich zu N, anzulegen, wobei die Bemusterung die Auswahl aus einem ersten Koeffizienten d des Ausgangsfensters, wobei 0≤d<N/M, einer definierten Gesamtheit von Koeffizienten N-d-1, N+d, 2N-d-1 umfasst, wobei eine vorbestimmte Bedingung einer perfekten Rekonstruktion eingehalten wird.

**15.** Informatikprogramm, umfassend Codebefehle für den Einsatz der Schritte des Codierungs- oder Decodierungsverfahrens nach einem der Ansprüche 1 bis 13, wenn diese Befehle von einem Prozessor ausgeführt werden.

**Claims**

**1.** Method of coding or decoding a digital audio signal by transform using analysis ($h_a$) or synthesis ($h_s$) weighting windows applied to sample frames, **characterized in that** it comprises an irregular sampling (E10) of an initial window provided for a transform of given initial size N, to apply a secondary transform of size M different from N, the sampling step comprising the selection, from a first coefficient d of the initial window with 0≤d<N/M, of a defined set of coefficients N-d-1, N+d, 2N-d-1, observing a predetermined perfect reconstruction condition.

**2.** Method according to Claim 1, **characterized in that**, when N is greater than M, a decimation of the initial window is performed by retaining at least the coefficients of the defined set to obtain a decimated window.

**3.** Method according to Claim 2, **characterized in that** it comprises the selection of a second set of coefficients spaced apart by a constant difference with the coefficients of the defined set and **in that** the decimation is performed by also retaining the coefficients of the second set to obtain the decimated window.

**4.** Method according to Claim 3, **characterized in that** the decimation of a window of size 2N into a window of size 2M is performed according to the following equations:

$$\text{for}\quad k \in [0; M/2-1]$$

$$
\begin{bmatrix}
h^*(k) = h\left(\left\lceil k\frac{N}{M}\right\rceil + d\right) \\
h^*(2M - k - 1) = h\left(\left\lfloor 2N - 1 - k\frac{N}{M}\right\rfloor - d\right) \\
h^*(M + k) = h\left(\left\lceil N + k\frac{N}{M}\right\rceil + d\right) \\
h^*(M - k - 1) = h\left(\left\lfloor N - 1 - k\frac{N}{M}\right\rfloor - d\right)
\end{bmatrix}
$$

in which h* is the decimated analysis or synthesis window, h is the initial analysis or synthesis window, $\lfloor X \rfloor$ is the closest integer $\leq X$, $\lceil X \rceil$ is the closest integer $\geq X$ and d is the value of the first coefficient of the defined set.

5. Method according to Claim 1, **characterized in that**, when N is less than M, an interpolation is performed by inserting a coefficient between each of the coefficients of the set of defined coefficients and each of the coefficients of a set of adjacent coefficients to obtain an interpolated window.

6. Method according to Claim 5, **characterized in that** it comprises the selection of a second set of coefficients spaced apart by a constant difference with the coefficients of the defined set and **in that** the interpolation is performed by also inserting a coefficient between each of the coefficients of the second set and each of the coefficients of a set of adjacent coefficients to obtain the interpolated window.

7. Method according to either of Claims 5 and 6, **characterized in that** it comprises the computation of a complementary window comprising coefficients computed from the defined coefficients of the set and from the adjacent coefficients, to interpolate said window.

8. Method according to any one of Claims 1 to 7, **characterized in that** the irregular sampling step and a decimation or interpolation of the initial window are performed during the step of implementing the temporal folding or unfolding used for the computation of the secondary transform.

9. Method according to any one of Claims 1 to 7, **characterized in that** both a decimation and an interpolation of the initial window are performed during the step of implementing the temporal folding or unfolding used for the computation of the secondary transform.

10. Method according to Claim 8, **characterized in that** the decimation during the temporal folding is performed according to the following equation:

$$
\begin{bmatrix}
T_M(k) = -T_{2M}\left(\frac{3M}{2} - k - 1\right)h_a\left(\left\lceil\frac{3N}{2} - (k+1)\frac{N}{M}\right\rceil + d\right) - T_{2M}\left(\frac{3M}{2} + k\right)h_a\left(\left\lfloor\frac{3N}{2} - 1 + (k+1)\frac{N}{M}\right\rfloor - d\right) \\
T_M(M/2 + k) = T_{2M}(k)h_a\left(\left\lceil k\frac{N}{M}\right\rceil + d\right) - T_{2M}(M - k - 1)h_a\left(\left\lfloor N - 1 - k\frac{N}{M}\right\rfloor - d\right)
\end{bmatrix}
$$
$$k \in [0; M/2-1]$$

with $T_M$ being a frame of M samples, $T_{2M}$, a frame of 2M samples.

11. Method according to Claim 8, **characterized in that** the decimation during the temporal unfolding is performed according to the following equation:

$$\begin{bmatrix} T^*_{2M}(k) = T^*_M\left(\tfrac{M}{2}+k\right)h_s\left(\left\lceil k\,\tfrac{N}{M}\right\rceil + d\right) \\ T^*_{2M}\left(\tfrac{M}{2}+k\right) = -T^*_M(M-k-1)h_s\left(\left\lfloor \tfrac{N}{2}-1+(k+1)\tfrac{N}{M}\right\rfloor - d\right) \\ T^*_{2M}(M+k) = -T^*_M\left(\tfrac{M}{2}-k-1\right)h_s\left(\left\lceil N+k\,\tfrac{N}{M}\right\rceil + d\right) \\ T^*_{2M}\left(\tfrac{3M}{2}+k\right) = -T^*_M(k)h_s\left(\left\lfloor \tfrac{3N}{2}-1+(k+1)\tfrac{N}{M}\right\rfloor - d\right) \end{bmatrix}$$

$$k \in [0; N/2-1]$$

with $T^*_M$ being a frame of M samples, $T^*_{2M}$, a frame of 2M samples.

12. Method according to Claims 7 and 9, **characterized in that**, when the secondary transform is of size M=3/2N, a decimation of the initial window followed by an interpolation is performed during the temporal folding according to the following equations:

$$\begin{bmatrix} T_M(k+1) = -T_{2M}\left(\tfrac{3M}{2}-(k+1)-1\right)h\left(\tfrac{3N}{2}-k/2-1\right) - T_{2M}\left(\tfrac{3M}{2}+k+1\right)h\left(\tfrac{3N}{2}+k/2\right) \\ T_M(k) = -T_{2M}\left(\tfrac{3N}{2}-k-1\right)hcomp\left(\tfrac{3N}{2}-k/2-1\right) - T_{2M}\left(\tfrac{3N}{2}+k\right)hcomp\left(\tfrac{3N}{2}+k/2\right) \\ T_M(N/2+k) = T_{2M}(k)h(k/2) - T_{2M}(N-k-1)h(N-k/2-1) \\ T_M(N/2+k+1) = T_{2M}(k+1)hcomp(k/2) - T_{2M}(N-(k+1)-1)hcomp(N-k/2-1) \end{bmatrix}$$

$$k/2 \in [0; N/2-1]$$

with $T_M$ being a frame of M samples, $T_{2M}$, a frame of 2M samples, hcomp the complementary window.

13. Method according to Claims 7 and 9, **characterized in that**, when the secondary transform is of size M=3/2N, a decimation of the initial window followed by an interpolation is performed during the temporal unfolding according to the following equations:

$$\begin{bmatrix} T^*_{2M}(k) = T^*_M\left(\tfrac{N}{2}+k\right)h(2N-k/2-1) \\ T^*_{2M}(k+1) = T^*_M\left(\tfrac{N}{2}+k+1\right)hcomp(2N-k/2-1) \\ T^*_{2M}\left(\tfrac{N}{2}+k+1\right) = -T^*_M(N-(k+1)-1)h\left(\tfrac{3N}{2}-k/2-1\right) \\ T^*_{2M}\left(\tfrac{N}{2}+k\right) = -T^*_M(N-k-1)hcomp\left(\tfrac{3N}{2}-k/2-1\right) \\ T^*_{2M}(N+k) = -T^*_M\left(\tfrac{N}{2}-k-1\right)h(N-k/2-1) \\ T^*_{2M}(N+k+1) = -T^*_M\left(\tfrac{N}{2}-(k+1)-1\right)hcomp(N-k/2-1) \\ T^*_{2M}\left(\tfrac{3N}{2}+k+1\right) = -T^*_M(k+1)h\left(\tfrac{N}{2}-k/2-1\right) \\ T^*_{2M}\left(\tfrac{3N}{2}+k\right) = -T^*_M(k)hcomp\left(\tfrac{N}{2}-k/2-1\right) \end{bmatrix}$$

$$k/2 \in [0; N/2-1]$$

with $T_M$ being a frame of M samples, $T_{2M}$, a frame of 2M samples, hcomp the complementary window.

14. Device for coding or decoding a digital audio signal by transform using analysis ($h_a$) or synthesis ($h_s$) weighting windows applied to sample frames, **characterized in that** it comprises a sampling module (102, 112) configured for irregularly sampling an initial window provided for a transform of given initial size N, in order to apply a secondary transform of size M different from N, the sampling comprising the selection, from a first coefficient d of the initial window with 0≤d<N/M, of a defined set of coefficients N-d-1, N+d, 2N-d-1, observing a predetermined perfect reconstruction condition.

**15.** Computer program comprising code instructions for the implementation of the steps of the coding or decoding method according to one of Claims 1 to 13, when these instructions are run by a processor.

COD

FIG. 1

**FIG. 2**

## FIG. 3a

## FIG. 3b

FIG. 4 (a)

FIG. 4 (b)

**FIG. 5**

**EP 2 732 448 B1**

## RÉFÉRENCES CITÉES DANS LA DESCRIPTION

**Documents brevets cités dans la description**

- EP 2319039 A